# EUROPÄISCHE PATENTSCHRIFT

(11) **EP 1 441 359 B1**
(45) Veröffentlichungstag und Bekanntmachung des Hinweises auf die Patenterteilung: **06.08.2008**
(21) Anmeldenummer: 03030003.2
(22) Anmeldetag: 31.12.2003
(51) Int. Cl.: G11C 7/10, G06F 13/40, G06F 13/16

(54) **Speichervorrichtung für eine Multibus-Architektur**
Memory system for a multibus architecture
Système de mémoire pour une architecture multibus

(30) Priorität: 22.01.2003 DE 10302287
(43) Veröffentlichungstag der Anmeldung: 28.07.2004
(73) Patentinhaber: Micronas GmbH, 79108 Freiburg i. Br. (DE)
(72) Erfinder: Herz, Ralf, 79111 Freiburg (DE); Noeske, Carsten, 79286 Glottertal (DE)
(74) Vertreter: Patentanwälte Westphal, Mussgnug & Partner

(56) Entgegenhaltungen:
- EP-A- 0 458 614
- EP-A- 0 811 923
- DE-A- 2 532 915
- US-A- 5 202 856
- US-A- 5 408 627

## Beschreibung

Die Erfindung bezieht sich auf eine Speichervorrichtung für eine Multibus-Architektur mit den oberbegrifflichen Merkmalen des Patentanspruchs 1.

Ein solche Speichervorrichtung ist aus US 5,408,627 bekannt.

Um in Signalprozessoren einen hohen Datendurchsatz zu erreichen, verfügen diese oft über mehrere angeschlossene Lese-/Schreibbusse, über welche gleichzeitig auf einen Datenspeicher zugegriffen werden kann. Die Ansteuerung von Speicheradressen erfolgt dabei über die Lese-/Schreibbusse durch abwechselndes Übertragen von Adress- und Informationsdaten oder durch das Übertragen von Adressen über einen separaten Adressbus.

Bei derartigen Anordnungen eines oder mehrerer Datenspeicher an mehreren Bussen, d. h. einer Multibus-Architektur, ist die Anbindung als solches nachteilhaft gelöst. Für einen effizienten Speicherzugriff zum Speichern von Daten in dem Speicher oder Auslesen von Daten aus dem Speicher sind derzeit zwei Ansätze üblich. Entweder wird ein Mehrport-Speicher eingesetzt, der mehrere Speicheranschlüsse zum Zugriff auf die verschiedenen Busse aufweist, oder die verschiedenen Busse sind nur an jeweils voneinander abgetrennten Speicherblöcken angeschlossen.

Ersteres hat den Nachteil, dass ein Mehrport-Speicher aufwändiger zu implementieren ist, als ein Einport-Speicher. Zweiteres hat den Nachteil, dass die Trennung der Speicherblöcke negative Auswirkungen auf die Programmflexibilität und auf die Ausführungsgeschwindigkeit hat. So muss z. B. die Speicheraufteilung im Programmcode definiert werden, was in Hochsprachen, z. B. C, oftmals nicht vorgesehen ist.

Die Aufgabe der Erfindung besteht darin, eine Speichervorrichtung für eine Multibus-Architektur vorzuschlagen, welche einen effizienteren Speicherzugriff ermöglicht.

Diese Aufgabe wird durch eine Speichervorrichtung für eine Multibus-Architektur mit den Merkmalen des Patentanspruchs 1, gelöst.

Ausgegangen wird von der Speichervorrichtung für eine Multibus-Architektur mit zumindest einem Speicher zum Speichern von Daten, Informationen und/oder Adressen, einem Speicheranschluss mit einem Port zum Anschließen des Speichers an einen ersten Bus einer Multibus-Architektur, wobei der Speicheranschluss, der Port und der erste Bus Datenleitungen zum Übertragen der Daten und gegebenenfalls Adressleitungen zum Übertragen von Adressen und/oder Steuerinformationen zum Ansteuern des Speichers und gegebenenfalls anderer am jeweiligen Bus angeschlossener Einrichtungen aufweist.

Eine Schalteinrichtung dient zum wahlweisen Anschließen des Speicheranschlusses an den ersten Bus oder einen weiteren der Busse für einen Speicherzugriff zum Übertragen von Daten, Adressen und/oder Steuerinformationen von oder zu diesen. Vorteilhafterweise weist eine Speicheranordnung, insbesondere eine Speicheranordnung in einem Prozessor oder in direkter Schaltung mit einem Prozessor, eine Vielzahl solcher Speichervorrichtungen auf, welche verfahrensgemäß an wahlweise jeweils einen der verschiedenen Busse angeschaltet werden.

Vorteilhafte Ausgestaltungen sind Gegenstand abhängiger Ansprüche.

Die Speichervorrichtung weist vorteilhafterweise eine speicherspezifische Logikeinrichtung und eine Unterbrechungsleitung zum Übertragen eines Unterbrechungssignals zum Prozessor auf, welcher die Gesamtanordnung steuert, wobei durch das Senden des Unterbrechungssignals eine Unterbrechung des Prozessorfortschritts dann für einen Takt ausgelöst wird, wenn ein Speicherzugriff des Speichers auf bzw. auf den Speicher von zwei verschiedenen der Busse innerhalb von zwei aufeinanderfolgenden Takten erfolgen soll.

Vorteilhafterweise weist der Speicher eine Adressanalyseeinrichtung zum Analysieren von Adressen auf den Bussen und/oder dem Speicher zugeordneten Adressleitungen für Speicherzugriffe und zum entsprechenden Schalten der Schalteinrichtung auf einen der entsprechenden der Busse auf.

Die Analyseeinrichtung dient zum Analysieren eines Teils der Adressen und zum Schalten und Zuordnen eines Speicherzugriffs für Adressteile kleiner der Wortbreite eines die Adressen übertragenden Busses bzw. der Adressleitungen, so dass der Speicher kleiner als der eigentlich erforderliche Speicherplatz sein kann. Weitere zu speichernde Daten werden in einem anderen Speicher abgelegt.

Eine einstellbare, insbesondere programmierbar einstellbare Separatoreinrichtung zum Ablegen der Speicher- bzw. Zugriffsadresse für den Speicher für die Analyse durch die Analyseeinrichtung ermöglicht dem Speicher, beliebige Adressen zuzuweisen, um z. B. externe Speicher überdecken zu können.

Die Analyseeinrichtung weist vorteilhafterweise eine gemeinsame Zugriffssteuereinrichtung für das Schalten der Schalteinrichtung und jeweils pro Bus eine Vergleichereinrichtung zum Vergleichen der Adresse mit der Speicheradresse des Speichers auf, wodurch der Bauteilaufwand reduzierbar ist.

In der Analyseeinrichtung ist eine Modifizierungseinrichtung vorteilhaft, die für das Bearbeiten verschiedener Daten und/oder Zugriffstypen ausgebildet ist, die über von der Schalteinrichtung ausgewählten Daten-, Subadress- und/oder Zugriffssignal-Leitungen an einen Datenspeicherabschnitt des Speichers zum Übertragen der Zustände auf den Busleitungen anliegen.

Eine Logikeinrichtung zum Ausgeben eines Blockverlustsignals über eine Verlustleitung zum Prozessor dient zum Signalisieren für den Fall einer Abweichung von angekündigten und durchgeführten Datenübertragungen beim Speicherzugriff.

Eine bevorzugte Speicheranordnung weist eine Vielzahl von solchen Speichern auf, die an einer Multibus-Architektur mit einer Vielzahl von Bussen angeschlossen sind. Dabei können alle oder einzelne der Speicher auch nur an einen Teil der Busse anschaltbar sein.

Insbesondere im Fall eines Wechsels zwischen Lese- und Schreibzugriff für einen der Speicher werden verschiedene der Speicher durch einen gemeinsamen Prozess taktweise abwechselnd angesteuert.

Vorteilhaft ist der Einsatz solcher Speicher insbesondere als Speicher für einen Prozessor.

Vorteilhafterweise wird ein Unterbrechungssignal zum Aussetzen des Prozessortaktes eines übergeordneten Prozessors oder zum Wählen eines anderen Speichers durch eine speicherspezifische Logikeinrichtung erzeugt und ausgesendet, wenn ein Speicherzugriff des Speichers auf zwei verschiedene der Busse oder zweier verschiedener Busse auf den Speicher innerhalb von zwei aufeinanderfolgenden Takten erfolgen soll, um Datenverluste vermeiden zu können.

Ein Steuersignal wie ein Taktsteuersignal zum Unterbrechen des Prozes'sortaktes oder wie ein Speicherauswahlsignal zum Auswählen einer anderen Speichervorrichtung durch den Prozessor mittels der Logik zu erzeugen und zum Prozessor zu senden, verhindert Datenverluste oder Ausfallzeiten bei Umschaltvorgängen zwischen Lese- und Schreibzuständen.

Für Speicherzugriffe werden dem Speicher zugeordnete Adressleitungen auf den Bussen oder separate Adressleitungen zum Bestimmen der Schaltstellung der Schalteinrichtung analysiert.

Dabei können auch Adressteile kleiner der Wortbreite der Adresse als zugeordnete Speicheradresse bei der Analyse gesucht und als Schaltkriterium verwendet werden, dies vorteilhafterweise bei Verteilung von Daten auf mehrere solcher Speicher.

Dazu kann ein Verfahren verwendet werden, bei dem die höchstwertigen Bit der Adresse zur Bestimmung der Zugriffsadresse mit einem einstellbaren, insbesondere programmierbar einstellbaren Register verglichen und der Speicherzugriff nur bei Übereinstimmung freigegeben wird.

Diese Verfahrensweise kann z. B. zum Durchführen eines Overlay-Verfahrens eingesetzt werden, bei dem ein anderer, insbesondere langsamerer und größerer Speicher überdeckt wird.

Zum Steuern der Schalteinrichtung werden ausgewählte Daten-, Subadress- und/oder Zugriffssignal-Leitungen eines ausgewählten Busses zum Erzeugen von Schalt- und Steuersignalen für den Fall verwendet, dass über den ausgewählten Bus übertragene Daten bzw. Informationen hinsichtlich des Datenumfangs nicht mit dem pro Speicher-Zugriffsschritt verfügbaren Speicherplatz-Umfang übereinstimmen.

Ausführungsbeispiele werden nachfolgend anhand der Zeichnung näher erläutert. Es zeigen:
- Fig. 1: schematisch eine Speichervorrichtung mit einem Speicher, der mittels einer Schalteinrichtung an verschiedene Busse einer Multibus-Architektur angeschlossen werden kann; und
- Fig. 2: eine bevorzugte Speichervorrichtung mit einer detaillierteren Darstellung einzelner bevorzugter Komponenten einer Logik zum Steuern der Schalteinrichtung.

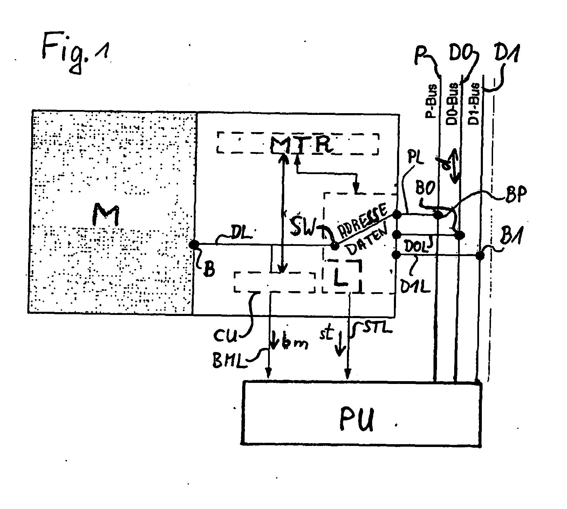

Wie dies aus Fig. 1 ersichtlich ist, ist eine beispielhafte Speichervorrichtung an eine Multibus-Architektur mit hier drei Bussen P, D0, D1 angeschlossen. Dabei sind die dargestellten und beschriebenen Einrichtungen und Funktionen nur beispielhaft zur Erläuterung des Grundprinzips eines Speichers M, welcher über eine Schalteinrichtung SW an wahlweise einen von mehreren Bussen P, D0, D1 der Multibus-Architektur angeschlossen werden kann. Weitere für den Betrieb einer solchen Speichervorrichtung gegebenenfalls erforderliche Komponenten, beispielsweise Adress- und sonstige Steuerbusse, sind gemäß dem üblichen Fachwissen hinzuzufügen.

Vorteilhafterweise wird ein solcher Speicher M gemäß der bevorzugten Ausführungsform als Speicher M an einer Multibus-Architektur eines Prozessors PU ausgebildet und angeordnet. Zweckmäßigerweise weist der Prozessor PU eine Speicheranordnung mit Vielzahl derartiger Speicher M auf, von denen je Bus einer gleichzeitig für einen Speicherzugriff angesteuert werden kann. Unter einem Speicherzugriff ist dabei einerseits das Beschreiben eines Speichers M mit Daten, insbesondere Informationsdaten, und andererseits das Auslesen von solchen Daten aus einem Speicherbereich des Speichers M über einen der Busse P, D0, D1 zu verstehen. Die dargestellten Busse P, D0, D1 führen direkt in den Prozessor PU, wobei diesbezüglich erforderliche Steuereinrichtungen, Schnittstellenkomponenten und dergleichen nicht dargestellt sind, da diese in üblicher Art und Weise ausgeführt werden können. Selbiges gilt für Steuerleitungen BML, STL zum Übertragen z.B. eines Blockverlustsignals bm beziehungsweise eines Unterbrechungssignals st oder auch weiterer Steuersignale.

Der eigentliche Speicher bzw. Speicherbereich M der Speichervorrichtung weist einen Speicheranschluss B in Form eines Speicherports üblicher Art und Weise auf. Der Speicheranschluss ist über Datenleitungen DL bzw. die Datenleitungen DL eines Datenbusses mit einer Schalteinrichtung SW verbunden. Die Schalteinrichtung SW schaltet die Datenleitungen DL über entsprechende Leitungen PL, D0L, D1L und entsprechende externe Ports BP, B0, B1 an wahlweise einen der Busse P, D0 oder D1.

Zum Schalten der Schalteinrichtung SW dient eine Logik L, welche in Verbindung mit vorzugsweise weiteren Einrichtungen, beispielsweise einem Speicher-Separator-Register (Memory Tag Register) MTR und zumindest einem Vergleicher CU verbunden ist. Die Blockverlustleitung BML geht dabei beispielsweise vom Vergleicher CU aus zum Prozessor PU, während die Unterbrechungssignalleitung STL von der Logikeinrichtung L selber zum Prozessor PU führt.

In bevorzugter Ausführungsform wird ein üblicher gemeinsamer Datenspeicher als Speicheranordnung des Prozessors PU in mehrere Blöcke unterteilt, welche wie der dargestellte Speicher M jeweils nur einen einzigen internen Zugriffsanschluss B aufweisen. An jeden dieser Speicher M werden mehrere Lese-/Schreibbusse P, D0, D1 über die Schalteinrichtung SW angeschlossen. Die in dem Block integrierte Logik L steuert als eine Zugriffssteuerungseinrichtung den Speicherzugriff der verschiedenen Busse auf den Block und den darin befindlichen Speicher M bzw. des Speichers M auf einen der Busse P, D0, D1. Natürlich muss bei einer solchen Anordnung nicht zwingend jeder der Speicher M an jeweils alle der Busse P, D0, D1 anschaltbar sein.

Soll von zwei der Busse P, D0, D1 zur gleichen Zeit auf den gleichen Speicher M zugegriffen werden, sendet die Logikeinrichtung L das Unterbrechungssignal st über die Unterbrechungssignalleitung STL zum Prozessor PU oder einer Taktsteuereinrichtung des Prozessors PU, um den Takt für den Prozessor für einen Taktzyklus auszusetzen oder den Prozessor für einen Takt anzuhalten, so dass nacheinander die Zugriffe auf die beiden anfordernden Busse mittels der Schalteinrichtung SW geschaltet und die entsprechenden Zustände auf den Busleitungen übertragen werden können. Alternativ kann aber auch eine entsprechende Programmierung und/oder Verschaltung des Prozessors PU das Aussetzen für einen Takt berücksichtigen.

Insbesondere ist ein Schreibzugriff in kleineren Einheiten als der Wortbreite der Busse möglich, ohne dabei einen Takt zu verlieren, also z. B. byte-weises Zugreifen bei einem 32-Bit-Bus. Das eigentliche Lesen-Modifizieren-Schreiben benötigt dabei wie üblich zwei Takte. Um den Taktverlust zu vermeiden, wird durch die dem Speicher M vorgelagerte Logik L und die weiteren damit verbundenen Einrichtungen entweder eine Zwischenspeicherung vorgenommen oder ein entsprechendes Zugriffssteuersignal st mit dem Prozessor PU ausgetauscht, damit dieser Speicher M im nächsten Taktzyklus nicht angesprochen wird, so dass der Prozessor PU nicht angehalten werden muss, sondern der Prozessor PU während des nächsten Taktzyklus auf einen anderen der Speicher M zugreift.

Vorteilhafterweise ist die speicherblockspezifische Logik L um einen Vergleicher CU erweiterbar, welcher die höchstwertigen Bit der Adresse mit einem einstellbaren, insbesondere über Programmierung einstellbaren Register vergleicht und nur bei Übereinstimmung arbeitet, so dass sich die einzelnen Speicher M einer Vielzahl solcher Speicher M beliebig im linearen Adressraum anordnen lassen. Beispielsweise kann ein Speicher eines langsamen externen Speichermoduls durch einen Speicherzugriff auf den Speicher M überdeckt werden und beim Beenden eines entsprechend dedizierten Programmabschnitts zurückkopiert werden. Dieses für sich als Overlay-Verfahren bekannte Verfahren erlaubt einen schnellen Zugriff auf die Daten, obwohl der interne Speicher M des Prozessors gegebenenfalls kleiner als der Speicher ist, welcher in der Anwendung benötigt wird. Zweckmäßigerweise wird ein größerer erforderlicher Speicherbereich somit durch eine Aufteilung auf mehrere kleinere Speicher M verwaltet.

Der in Fig. 1 dargestellte Speicher M weist nur eine Datenleitung bzw. einen Datenbus DL auf. Prinzipiell ist es möglich, über einen einzelnen Bus in zeitlicher Abfolge Adressdaten und Informationsdaten zu übertragen, wobei die Adressdaten jeweils angeben, zu welchen bzw. von welchen Speichern M oder Adressen innerhalb der Speicher M die Informationsdaten als eigentliche Daten d zu übertragen sind. Alternativ ist auch eine Verwendung eines separaten Adressbusses möglich, über welchen die reinen Adressdaten übertragen werden, so dass über den Datenbus DL nur reine Nutzdaten und gegebenenfalls weitere zusätzliche Adress- und Steuerinformationen übertragen werden.

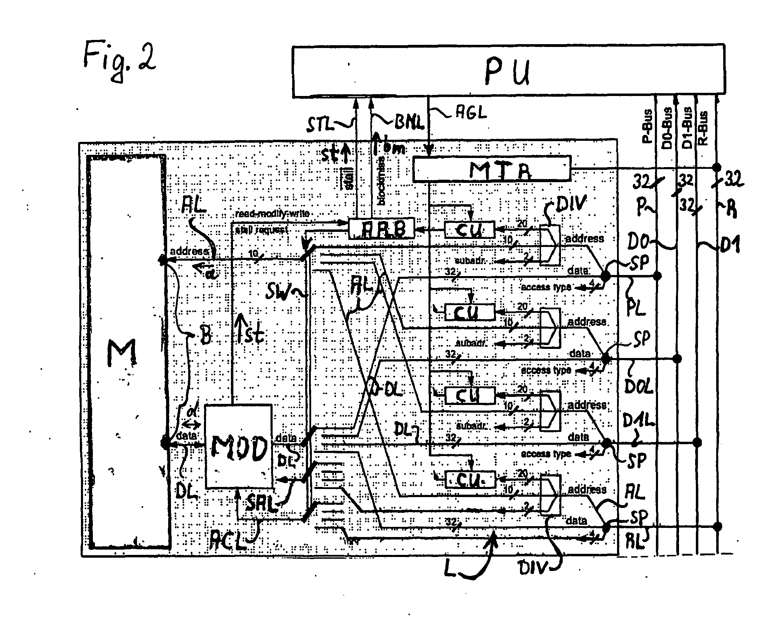

Fig. 2 stellt ein detaillierteres Ausführungsbeispiel dar, bei dem wiederum ein Speicher M mit vorzugsweise einer Vielzahl adressierbarer Speicherplätze über eine Schalteinrichtung SW an einen von mehreren Bussen P, D0, D1, R einer Multibus-Architektur schaltbar ist.

Bei dem dargestellten Beispiel ist der Speicheranschluss B in einen Adress-Speicheranschluss und einen Daten-Speicheranschluss aufgeteilt. Dem Adress-Speicheranschluss werden die über einen separaten Adressbus oder, wie vorstehend beschrieben, einen der Busse P, D0, D1, R übertragene Adressen zur Adressierung von internen Speicherplätzen des Speichers M angelegt. Dabei wird beim dargestellten Ausführungsbeispiel jeweils die Adressinformation von dem aktiv geschalteten der Busse P zugeführt.

Möglich ist dabei insbesondere, dass auch nur über den als Programmierbus ausgestalteten Bus P Adressen zugeführt werden, so dass regelmäßig oder jeweils nach Abschluss eines Speicherzugriffs die Schalteinrichtung SW eine Umschaltung zu dem Programmierbus P durchführt. Für einen Datenzugriff wird dann gegebenenfalls zu dem erforderlichen der weiteren Busse D0, D1, R umgeschaltet.

Ausgehend von den Bussen P, D0, D1, R, welche beispielsweise als 32-Bit-Busse ausgestaltet sind, führt eine 32-Bit-Leitung zu einem Dateneingangsschalter der Schalteinrichtung SW. Je nach Schaltstellung der Schalteinrichtung SW wird somit eine 32-Bit-Datenleitung bzw. ein 32-Bit-Datenbus DL von dem gewählten der Busse P, D0, D1, R über die Schalteinrichtung SW zu dem Daten-Speicheranschluss des Speicheranschlusses B geführt, um entsprechende Daten bzw. Leitungszustände in den zu diesem Moment adressierten Speicherbereich des Speichers M zu schreiben oder aus diesem auszulesen.

Die Datenleitung DL, welche von jedem der Busse P, D0, D1, R zu dem entsprechenden Schaltanschluss der Schalteinrichtung SW führt, weist am Eingang der aus vielen Einzelkomponenten bestehenden Logikeinrichtung L einen Splitter SP auf, welcher beispielsweise in Form eines Abgriffes ausgebildet ist, wobei die einzelnen der Datenleitungen des Datenbusses DL abgegriffen und als Adressleitungen AL einer Teilungseinrichtung DIV zugeführt werden. Die Teilungseinrichtung DIV teilt beim vorliegenden Beispiel zehn der Adressleitungen AL heraus und führt diese zu einem entsprechend geschalteten Adressleitungseingang der Schalteinrichtung SW. Je nach Schaltstellung wird entsprechend das Adresssignal des ausgewählten der Busse P, D0, D1, R an den Adress-Speichereingang des Speicheranschlusses B des Speichers M angelegt.

Außerdem werden aus der Teilungseinrichtung DIV zwei Adressleitungen SAL zum Übertragen von Subadressen herausgeteilt und einem entsprechend geschalteten Eingang der Schalteinrichtung SW zugeführt, welche die Subadresse des ausgewählten Busses P, D0, D1, R an eine Modifizierungseinrichtung MOD weiterleitet.

Die Splittereinrichtung SP splittet auch Datenleitungen, beispielsweise vier solche Leitungen ACL mit einer Information über den Zugriffstyp aus den eigentlichen Datenleitungen 32 heraus und führt diese zu einem entsprechend geschalteten Eingang der Schalteinrichtung SW. Diese legt die Signale bzw. Zustände der Adresstyp-Leitungen ACL je nach Schaltstellung vom ausgewählten der Busse P, D0, D1, R ebenfalls an die Modifizierungseinrichtung MOD an.

Die Modifizierungseinrichtung MOD ist außerdem zwischen die geschaltete Datenleitung DL und den Daten-Speicheranschluss B geschaltet. Die Modifizierungseinrichtung MOD dient zum Modifizieren der empfangenen Daten d des ausgewählten Busses P, D0, D1, R und berücksichtigt als Zugriffstyp insbesondere einen Schreib- oder Lesezugriff, die Tatsache, ob es sich um ein vollständiges Wort (word), ein gekürztes Wort (short) oder nur ein Byte von einem ursprünglichen Datenwort auf der Datenleitung DL handelt, welches beim Speicherzugriff zu übertragen ist, oder ob es sich um ein in irgendeiner Art und Weise erweitertes Zeichen oder Signal handelt.

Außerdem gibt die Modifizierungseinrichtung MOD u.a. ein Lese-Modifizier-Schreibsignal an eine Zugriffssteuereinrichtung ARB als weiterem Bestandteil der Logik L weiter. Die Zugriffssteuereinrichtung ARB steuert in Verbindung mit dem Prozessor PU den Zugriff auf den Speicher M. Die Zugriffssteuereinrichtung ARB steuert außerdem die Betätigung der Schalteinrichtung SW.

Vorteilhafterweise weist die Speicherlogik L als Adressanalyseeinrichtung oder Teil davon auch ein Speicher-Separator-Register (Memory Tag Register) MTR auf, welches beispielsweise über den Bus R mit einer Zugriffsadresse des Speichers M programmierbar ist. Das Speicher-Separator-Register MTR weist vorteilhafterweise auch eine Überlaufleitung AGL auf, um einen Speicherüberlaufschutz zu ermöglichen.

Von der Teilungseinrichtung DIV werden Adressleitungen, vorliegend 20 der Adressleitungen AL abgezweigt, welche jeweils einer Vergleichereinrichtung CU zugeführt werden. Die Vergleichereinrichtung CU vergleicht die derart empfangenen Adressdaten mit den im Speicher-Separator-Register MTR abgespeicherten Adressdaten und liefert das Vergleichsergebnis zur weiteren Verarbeitung an die Zugriffssteuereinrichtung ARB.

## Patentansprüche

1. Speichervorrichtung für eine Multibus-Architektur mit den Merkmalen:
- eine Vielzahl von Bussen (P, D0, D1) einer Multibus-Architektur,
**gekennzeichnet durch** die weiteren Merkmale :
- eine Vielzahl von Speicherblöcken (M) zum Speichern von Daten (d), Informationen und/oder Adressen,
- jeder der Speicherblöcke (M) weist einen Speicheranschluss (B) mit einem Port (B0) zum Anschließen des Speicherblocks (M) an einen der Busse (P, D0, D1) auf,
- jeder Speicheranschluss (B), der Port (B0) und der erste Bus (P) weist Datenleitungen (DL) zum Übertragen der Daten (d) und gegebenenfalls zum Übertragen von Adressen (a) und/oder Steuerinformationen zum Ansteuern des Speichers (M) auf,
- jedem der Speicherblöcke (M) ist eine Schalteinrichtung (SW) zugeordnet,
- jede der Schalteinrichtungen (SW) ist zum wahlweisen Anschließen des Speicheranschlusses (B) eines einzigen des jeweiligen Speicherblocks (M) an einen einzigen der Busse (P, D0, D1), für einen Speicherzugriff zum Übertragen von Daten, Adressen und/oder Steuerinformationen von bzw. zu diesem vorgesehen, wobei jedem der Schalteinrichtungen (SW) eine eigene, speicherblockspezifische Logikeinrichtung (L) zugeordnet ist, derart, dass je Bus (P, D0, D1) einer der Speicherblöcke (M) gleichzeitig für einen Speicherzugriff angesteuert werden kann.

2. Speichervorrichtung nach Anspruch 1 mit einer speicherspezifischen Logikeinrichtung (L) und einer Unterbrechungsleitung (STL) zum Übertragen eines Unterbrechungssignals (st) zu einer Prozessoranordnung (PU), zum Steuern der Gesamtanordnung derart, dass durch das Senden des Unterbrechungssignals (st) eine Unterbrechung des Prozessorfortschritts immer dann für einen Takt ausgelöst wird, wenn ein Speicherzugriff des Speicherblocks (M) auf zwei verschiedene der Busse (P, D0, D1, R) bzw. auf den Speicherblock (M) von diesen innerhalb von zwei aufeinanderfolgenden Takten erfolgen soll.

3. Speichervorrichtung nach Anspruch 1 oder 2 mit einer dem Speicherblock (M) vorgeschalteten Adressanalyseeinrichtung (ARB, CU) zum Erfassen von Adressen auf den Bussen und/oder dem Speicherblock (M) zugeordneten Adressleitungen (AL) für Speicherzugriffe und zum entsprechenden Schalten der Schalteinrichtung (SW) auf einen der entsprechenden der Busse (P, D0, D1).

4. Speichervorrichtung nach Anspruch 3, bei der die Analyseeinrichtung (ARB, CU) zum Erfassen eines Teils der Adressen und zum Schalten und Zuordnen eines Speicherzugriffs für Adressteile kleiner der Wortbreite eines die Adressen übertragenden Busses bzw. der Adressleitungen (AL) ausgebildet ist.

5. Speichervorrichtung nach Anspruch 3 oder 4 mit einer einstellbaren, insbesondere programmierbar einstellbaren Separatoreinrichtung (MTR) zum Ablegen einer Speicheradresse des Speicherblocks (M) für die Analyse durch die Analyseeinrichtung (ARB, CU).

6. Speichervorrichtung nach einem der Ansprüche 3 - 5, bei der die Analyseeinrichtung eine gemeinsame Zugriffssteuereinrichtung (ARB) für das Schalten der Schalteinrichtung (SW) und jeweils pro Bus (P, D0, D1, R) eine Vergleichereinrichtung (CU) zum Vergleichen der Adresse mit der Speicheradresse des Speicherblocks (M) aufweist.

7. Speichervorrichtung nach einem der Ansprüche 3 - 6, bei der die Analyseeinrichtung eine Modifizierungseinrichtung (MOD) aufweist, die für das Bearbeiten verschiedener Daten- und/oder Zugriffstypen ausgebildet ist, die über von der Schalteinrichtung (SW) ausgewählten Daten-, Subadress- und/oder Zugriffssignal-Leitungen (DL, SAL, ACL) an der Modifizierungseinrichtung (MOD) und/oder an einem Datenspeicherabschnitt des Speicherblocks (M) zum Übertragen der Zustände auf den Busleitungen (DL) anliegen.

8. Speichervorrichtung nach einem der vorstehenden Ansprüche mit einer bzw. der Logikeinrichtung (L, CU) zum Ausgeben eines Blockverlustsignals (BM) über eine Verlustleitung (BML) zu einer übergeordneten Prozessoranordnung (PU) für den Fall einer Abweichung von angekündigten und durchgeführten Datenübertragungen beim Speicherzugriff.

## Claims

1. A storage device for a multi-bus architecture, having the following features:
- a plurality of buses (P, D0, D1) of a multi-bus architecture,
**characterised by** the further features:
- a plurality of memory blocks (M) for storing data (d), information and/or addresses,
- each of the memory blocks (M) comprises a memory connection (B) with a port (B0) for the connection of the memory block (M) to one of the buses (P, D0, D1),
- each memory connection (B), the port (B0) and the first bus (P) comprises data lines (DL) for transmitting the data (d) and where appropriate for transmitting addresses (a) and/or control information for actuating the memory (M),
- a switching device (SW) is assigned to each of the memory blocks (M),
- each of the switching devices (SW) is provided to selectively connect the memory connection (B) of a single respective memory block (M) to a single bus (P, D0, D1), for memory access to transmit data, addresses and/or control information therefrom or thereto, whereby a separate memory-block-specific logic device (L) is assigned to each of the switching devices (SW) such that any one bus (P, D0, D1) of one of the memory blocks (M) can be simultaneously actuated for memory access.

2. A storage device according to claim 1, having a memory-specific logic device (L) and an interrupt line (STL) to transmit an interrupt signal (st) to a processor configuration (PU), to control the complete configuration such that by sending the interrupt signal (st), an interruption of the processor operation is always triggered for one clock cycle whenever a memory access by the memory block (M) is to be effected to two different buses (P, D0, D1, R), or to the memory block (M) by these buses, within two successive clock cycles.

3. A storage device according to claim 1 or 2, having an address analysis device (ARB, CU) connected on the input side of the memory block (M) for recording addresses on address lines (AL) assigned to the buses and/or the memory block (M) for memory access operations, and for appropriately switching the switching device (SW) to one of the corresponding buses (P, D0, D1).

4. A storage device according to claim 3, wherein the analysis device (ARB, CU) is designed to record a part of the addresses, and to switch and assign a memory access for address segments smaller than the word width of a bus transmitting the addresses or of the address lines (AL).

5. A storage device according to claim 3 or 4, having an adjustable separator device, specifically a programmably adjustable separator device (MTR), to store a memory address of the memory block (M) for analysis by the analysis device (ARB, CU).

6. A storage device according to claim 3 to 5, wherein the analysis device has a common access control device (ARB) to switch the switching device (SW), and one comparator (CU) to each bus (P, D0, D1, R) to compare the address with the memory address of the memory block (M).

7. A storage device according to one of claims 3 to 6, wherein the analysis device comprises a modifier device (MOD) which is designed to process different data types and/or access types which are applied to the modifier device (MOD) and/or to a data memory segment of the memory block (M) via data lines, sub-address lines, and/or access signal lines (DL, SAL, ACL) selected by the switching device (SW) in order to transmit states on the bus lines (DL).

8. A storage device according to one of the preceding claims, having a or the logic device (L, CU) to output a block loss signal (BM) via a loss line (BML) to a higher-level processor configuration (PU) in the event of a deviation from the announced and executed data transfers during the memory access.

## Revendications

1. Système de mémoire pour une architecture multi-bus ayant les caractéristiques suivantes :
- un ensemble de bus (P, D0, D1) d'une architecture multi-bus **caractérisé par** les caractéristiques suivantes :
- un ensemble de bloc de mémoire (M) pour mémoriser des données (d), des informations et/ou des adresses,
- chacun des blocs de (M) comporte un branchement de mémoire (B) avec un port (B0) pour brancher le bloc de mémoire (M) sur l'un des bus (P, D0, D1),
- chaque branchement de mémoire (B), le port (B0) et le premier bus (B) comportent des lignes de données (DL) pour transmettre des données (d) et le cas échéant pour transmettre des adresses (a) et/ou des informations de commande pour commander la mémoire (M),
- à chacun des blocs de mémoire (M) est associée une installation de commutation (SW),
- chacune des installations de commutation (SW) est prévue pour le branchement sélectif du branchement de mémoire (B) d'un unique bloc de mémoire respectif (M) sur un unique bus (P, D0, D1) pour un accès à la mémoire pour transmettre des données, des adresses et/ou des informations de commande à partir ou vers ce bloc, et à chacune des installations de commutation (SW) est associée sa propre installation logique (L) spécifique à ce bloc de mémoire de façon qu' un des blocs de mémoire (M) puisse être prévu pour un accès de mémoire par bus (P, D0, D1) .

2. Système de mémoire selon la revendication 1 comportant une installation logique (L) spécifique à la mémoire ainsi qu'une ligne d'interruption (STL) pour transmettre un signal d'interruption (ST) vers un processeur (PU), pour commander la disposition d'ensemble de façon que par l'envoi du signal d'interruption (ST) pour déclencher tou jours une interruption de la progression du processeur pour une cadence si un accès au bloc de mémoire (M) arrive par deux bus différents (P, D0, D1, R) ou au bloc de mémoire (M) au cours de deux cadences qui se suivent.

3. Système de mémoire selon la revendication 1 ou 2, comportant une installation d'analyse d'adresse (ARB, CU) en amont du bloc de mémoire (M) pour saisir les adresses sur les bus et/ou les lignes d'adresse associées au bloc de mémoire (M) pour les accès à la mémoire et pour commuter de façon correspondante l'installation de commutation (SW) sur l'un des bus correspondants (P, D0, D1).

4. Système de mémoire selon la revendication 3, selon lequel l'installation d'analyse (ARB, CU) est réalisée pour saisir une partie des adresses et pour commuter et associer un accès de mémoire aux parties d'adresse inférieures à la largeur d'un mot d'un bus ou des lignes d'adresse (AL) transmettant les adresses.

5. Système de mémoire selon la revendication 3 ou 4, comportant une installation de séparation (MTR), réglable, notamment programmable, pour enregistrer une adresse de bloc de mémoire (M) pour l'analyse par l'installation d'analyse (ARB, CU).

6. Système de mémoire selon l'une des revendications 3 à 5, selon laquelle l'installation d'analyse comporte une installation de commande d'accès commune (ARB) pour commuter l'installation de commutation (SW) et pour chaque bus (P, D0, D1, R), une installation de comparaison (CU) pour comparer l'adresse, à l'adresse du bloc de mémoire (M).

7. Système de mémoire selon l'une des revendications 3 à 6, selon laquelle l'installation d'analyse comporte une installation de modification (MOD) réalisée pour traiter différents types de données et/ou d'accès, qui sont appliqués par l'installation de commutation (SW) sélectionnant des lignes de données de sous-adresses et/ou de signaux d'accès (DL, SAL, ACL) dans l'installation de modification (MOD) et/ou dans un segment de mémoire de données du bloc de mémoire (M) pour transmettre les états aux lignes de bus (DL).

8. Système de mémoire selon l'une des revendications précédentes, comportant une installation, c'est-à-dire l'installation logique (L, CU) pour émettre un signal de perte de bloc (BM) par une ligne de perte (BML) vers un dispositif de processeur (PU), subordonné dans le cas d'un écart entre la transmission de données annoncée et celle effectuée pour un accès à la mémoire.
